# FASCICULE DE BREVET EUROPEEN

(11) **EP 0 863 546 B1**
(45) Date de publication et mention de la délivrance du brevet: **06.09.2006**
(21) Numéro de dépôt: 98410025.5
(22) Date de dépôt: 03.03.1998
(51) Int. Cl.: H01L 21/768, H01L 23/525, H01L 27/11

(54) **Pseudofusible et application à un circuit d'établissement d'une bascule à la mise sous tension**
Pseudoschmelzsicherung und ihre Anwendung bei einer Schaltung zum Setzen eines bistabilen Flip-Flop
Pseudo-fuse and its use in a circuit for setting a bistable flip-flop

(30) Priorité: 07.03.1997 FR 9702951
(43) Date de publication de la demande: 09.09.1998
(73) Titulaire: STMicroelectronics S.A., 92120 Montrouge (FR)
(72) Inventeur: Kalnitsky, Alexander, San Francisco, CA 94116 (US); Ferrant, Richard, 38330 Saint Ismier (FR)
(74) Mandataire: de Beaumont, Michel

(56) Documents cités:
- WO-A-93/03500
- WO-A-97/12401
- DE-A- 4 005 851
- DE-A- 4 022 398
- US-A- 5 493 147

## Description

La présente invention vise à la réalisation d'un pseudofusible, c'est-à-dire d'un élément présentant un premier état de faible résistance et un deuxième état de plus forte résistance et pouvant passer du premier au deuxième état par suite du passage d'un courant.

La présente invention vise aussi une application d'un tel pseudofusible à la réalisation d'une bascule bistable qui est automatiquement programmée dans son premier ou son deuxième état par suite de sa mise sous tension, en fonction de l'état du pseudofusible.

Pour atteindre ces objets, la présente invention prévoit un pseudofusible comprenant entre deux contacts une région de silicium revêtue d'une région de siliciure comprenant une portion de section réduite revêtue d'une couche de diélectrique.

Selon un mode de réalisation de la présente invention, le diélectrique est de l'oxyde de silicium.

Selon un mode de réalisation de la présente invention, le siliciure est un siliciure de titane.

Selon un mode de réalisation de la présente invention, la région de silicium est du silicium polycristallin dopé.

La présente invention prévoit aussi l'application de tels pseudofusibles à la réalisation d'un circuit pour la mise dans un état déterminé à la mise sous tension d'une bascule bistable, dans lequel le pseudofusible est disposé dans une branche de la bascule bistable, une résistance de valeur déterminée, intermédiaire entre les valeurs haute et basse du pseudofusible, étant disposée dans l'autre branche.

Selon un mode de réalisation de la présente invention, la bascule bistable comprend dans chacune des branches un transistor à canal P en série avec un transistor à canal N, les grilles des transistors de la première branche étant reliées au point de connexion des transistors de la deuxième branche et les grilles des transistors de la deuxième branche étant reliées au point de connexion des transistors de la première branche.

Selon un mode de réalisation de la présente invention, le circuit comprend des moyens de reprogrammation de la bascule bistable.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B représentent respectivement une vue de dessus et une vue en coupe d'un mode de réalisation d'un pseudofusible selon la présente invention ; et
les figures 2 et 3 représentent des exemples d'application d'un pseudofusible selon la présente invention.

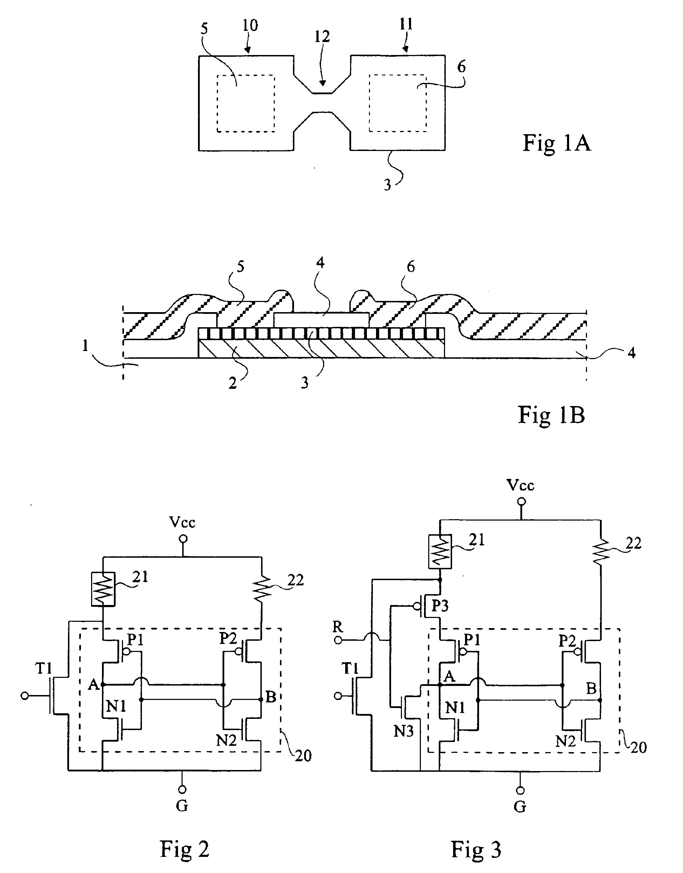

Dans le mode de réalisation des figures 1A et 1B, le pseudofusible selon la présente invention est formé au-dessus d'une couche isolante 1 et comprend une région de silicium polycristallin 2 dont la surface supérieure 3 est siliciurée.

L'ensemble est revêtu d'une couche d'un diélectrique 4 dans laquelle sont formées des ouvertures pour établir des contacts avec des métallisations 5 et 6. Ces ouvertures sont formées en des emplacements distants de la surface supérieure de la couche de siliciure 3.

Dans la vue de dessus de la figure 1A, on voit que l'ensemble des régions 2 et 3 comporte deux portions externes 10 et 11 propres à servir de plots de contact avec les métallisations 5 et 6, et une partie centrale de section réduite 12. Dans le mode de réalisation représenté, la section réduite correspond à une portion de largeur réduite des deux régions 2 et 3. On pourrait aussi prévoir une zone de siliciure d'épaisseur réduite ou un rétrécissement de la seule région de siliciure.

La région 2 a été définie comme étant une couche de silicium polycristallin. Il pourra aussi s'agir de la surface supérieure d'un substrat de silicium. Cette région 2 est dopée selon un type de conductivité souhaité pour présenter une résistivité choisie et une résistance déterminée entre les contacts 5 et 6.

Le siliciure 3 est un siliciure de métal réfractaire tel qu'un siliciure de titane. Sa caractéristique essentielle dans la présente invention est de présenter un point de fusion inférieur à celui du silicium.

La couche de diélectrique 4 est par exemple une couche d'oxyde de silicium.

Ainsi, quand la structure est dans l'état illustré en figure 1B, elle présente une première résistance faible essentiellement due à la forte conductivité de la région de siliciure. Cet état sera appelé ci-après état vierge.

Si l'on fait passer un courant élevé entre les bornes 5 et 6, le siliciure s'échauffe, notamment dans la région 12 et réagit avec le diélectrique 4 qui le recouvre pour former un composé non-conducteur. Alors, la résistance entre les régions 5 et 6 est liée au niveau de dopage de la région de silicium 2 et atteint une valeur nettement plus élevée. Cet état sera appelé ci-après état programmé.

On dispose ainsi d'un fusible. Toutefois, contrairement à un fusible normal qui présente dans un premier état une résistance faible et dans un deuxième état une résistance pratiquement infinie, le fusible ou pseudofusible selon la présente invention présente dans un premier état une première valeur de résistance faible et dans un deuxième état une deuxième valeur de résistance plus élevée et déterminée, notamment par le niveau de dopage de la région de silicium 2.

Un tel pseudofusible dont la résistance peut varier entre deux valeurs déterminées, peut trouver diverses applications qui apparaîtront à l'homme de l'art. On indiquera ci-après, uniquement à titre d'exemple, une application possible d'un tel pseudofusible à l'établissement dans un état déterminé d'une bascule bistable à la suite d'une mise sous tension de cette bascule.

La figure 2 représente un premier exemple d'une telle application. Le bloc 20 désigne une bascule bistable dont une première branche est connectée entre une alimentation haute V_{CC} et la masse G avec interposition d'un fusible selon la présente invention 21. La deuxième branche est également connectée entre les bornes V_{CC} et G avec interposition d'une résistance 22 de valeur R. Cette valeur R est choisie pour être supérieure à la valeur RF1 de la résistance du fusible quand celui-ci est à l'état vierge et pour être inférieure à la valeur RF2 de la résistance du fusible quand celui-ci a été programmé. Un commutateur T1, par exemple un transistor MOS à canal N est disposé en série avec le fusible 21 entre les bornes V_{CC} et G. Ainsi, quand une tension est appliquée entre les bornes V_{CC} et G, la mise en conduction du commutateur T1 entraîne le passage du fusible 21 dans l'état programmé.

La bascule 20 est déséquilibrée du fait des valeurs inégales des résistances 21 et 22. Au moment où l'on applique la tension sur la borne V_{CC}, la capacité associée à la branche de la bascule dont la résistance est la plus faible se charge plus rapidement que celle de l'autre branche. Ainsi, quand le fusible 21 a une résistance plus faible que la résistance R1, c'est la branche associée à cette résistance qui se charge la première et la bascule prend un premier état. Dans le cas contraire, la bascule prend un deuxième état.

Dans l'exemple particulier représenté, la bascule bistable 20 est du type SRAM. La première branche comprend un transistor MOS à canal P P1 en série avec un transistor MOS à canal N N1. La deuxième branche comprend un transistor MOS à canal P P2 en série avec un transistor MOS à canal N N2. Les grilles des transistors P2 et N2 sont connectées au point de raccordement A des transistors P1 et N1. Les grilles des transistors P1 et N1 sont connectées au point de raccordement B des transistors P2 et N2. A un état initial où la tension V_{CC} n'est pas appliquée, le potentiel des noeuds A et B est nul. Quand la tension V_{CC} croît progressivement, les transistors P1 et P2 sont passants puisqu'il s'agit de transistors à canal P dont la grille est à niveau nul et les capacités équivalentes des transistors N1 et N2 se chargent. C'est le noeud A ou B de la branche à laquelle la résistance la plus faible est associée qui se chargera le plus rapidement et dès que la tension au point A ou B atteint un seuil de transistor, le transistor P1 ou P2 se bloquera et le transistor N1 ou N2 deviendra passant, ce qui confère à la cellule un état déterminé fonction de la valeur de la résistance du pseudofusible 21 par rapport à la valeur de la résistance R2. Ceci permet de fournir des cellules mémoire SRAM qui atteignent un état déterminé après une mise sous tension. Cet état pourra être utilisé pour déclencher diverses opérations, par exemple pour inhiber des lignes d'une mémoire auxquelles sont associées ces cellules.

La figure 3 représente une variante de ce circuit dans lequel l'état de la cellule préprogrammée est modifiable. En plus des éléments déjà décrits en relation avec la figure 2, le circuit de la figure 3 comprend dans la première branche un transistor MOS à canal P P3, et un transistor MOS à canal N N3 est connecté entre le noeud A et la masse G. Les grilles des transistors P3 et N3 sont connectées à une borne de remise à zéro R. Ainsi, quand un signal est appliqué sur la borne R, le transistor N3 devient passant et le transistor P3 se bloque, d'où il résulte que le noeud A est remis à la masse.

Bien entendu, diverses variantes de reprogrammation du circuit peuvent être prévues et d'autres types de bascules bistables que celles représentées en figures 2 et 3 peuvent être utilisés.

## Revendications

1. Fusible présentant un premier état de faible résistance et un deuxième état de plus forte résistances et pouvant passer du premier au deuxième état par suite du passage d'un courant, comprenant entre deux contacts (5, 6) une région de silicium dopé (2) revêtue d'une région de siliciure (3) comprenant une portion (12) de section réduite revêtue d'une couche de diélectrique (4).

2. Fusible selon la revendication 1, **caractérisé en ce que** le diélectrique (4) est de l'oxyde de silicium.

3. Fusible selon la revendication 1, **caractérisé en ce que** le siliciure (3) est un siliciure de titane.

4. Fusible selon la revendication 1, **caractérisé en ce que** la région de silicium dopé (2) est du silicium polycristallin

5. Circuit utilisant le fusible selon la revendication 1 pour la mise dans un état déterminé à la mise sous tension d'une bascule bistable (20), **caractérisé en ce que** le fusible (21) est disposé dans une branche de la bascule bistable, une résistance (22) de valeur déterminée, intermédiaire entre les valeurs haute et basse du fusible, étant disposée dans l'autre branche.

6. Circuit selon la revendication 5, **caractérisé en ce que** la bascule bistable comprend dans chacune des branches un transistor à canal P en série avec un transistor à canal N, les grilles des transistors (P1, N1) de la première branche étant reliées au point de connexion (B) des transistors de la deuxième branche et les grilles des transistors (P2, N2) de la deuxième branche étant reliées au point de connexion (A) des transistors de la première branche.

7. Circuit selon la revendication 5 ou 6, **caractérisé en ce qu'**il comprend des moyens (P3, N3) de reprogrammation de la bascule bistable.

## Claims

1. A fuse having a first state of low resistance and a second state of higher resistance and which can switch from the first to the second state at the passing of a current, including between two contacts (5, 6) a doped silicon region (2) coated with a silicide region (3) including a portion (12) of reduced section coated with a dielectric layer (4).

2. The fuse of claim 1, **characterized in that** the dielectric (4) is silicon oxide.

3. The fuse of claim 1, **characterized in that** the silicide (3) is a titanium silicide.

4. The fuse of claim 1, **characterized in that** the doped silicon region (2) is polysilicon.

5. A circuit using the fuse of claim 1 for setting to a determined state upon power-on of a bistable latch (20), **characterized in that** the fuse (21) is placed in a branch of the bistable latch, a resistor (22) of determined value, intermediary between the high and low values of the fuse, being placed in the other branch.

6. The circuit of claim 5, **characterized in that** the bistable latch includes in each of the branches a P-channel transistor in series with an N-channel transistor, the gates of the transistors (P1, N1) of the first branch being connected to the connection node (B) of the transistors of the second branch and the gates of the transistors (P2, N2) of the second branch being connected to the connection node (A) of the transistors of the first branch.

7. The circuit of claim 5 or 6, **characterized in that** it includes means (P3, N3) for reprogramming the bistable latch.

## Patentansprüche

1. Eine Sicherung mit einem ersten Zustand mit niedrigem Widerstand und einem zweiten Zustand mit höherem Widerstand, die von dem ersten zu dem zweiten Zustand schalten kann beim Durchleiten eines Stroms, wobei die Sicherung zwischen zwei Kontakten (5, 6) einen dotieren Siliziumbereich (2) aufweist, der mit einem Silizidbereich (3) beschichtet ist, einschließlich eines Teils (12), eines reduzierten Querschnitts, der mit einer dielektrischen Schicht (4) beschichtet ist.

2. Sicherung nach Anspruch 1, **dadurch gekennzeichnet, dass** die dielektrische Schicht (4) Siliziumoxid ist.

3. Sicherung nach Anspruch 1, **dadurch gekennzeichnet, dass** das Silizid (3) ein Titansilizid ist.

4. Sicherung nach Anspruch 1, **dadurch gekennzeichnet, dass** der dotiere Siliziumbereich (2) Polisilizium ist.

5. Eine Schaltung, die die Sicherung gemäß Anspruch 1 verwendet zum Einstellen eines vorbestimmten Zustandes beim Hochfahren eines Bistable Latch bzw. einer zwei Zustände aufweisenden Verriegelung (20), **dadurch gekennzeichnet, dass** die Sicherung (21) in einem Zweig des Bistable Latchs platziert ist, und ein Widerstand (22) mit vorbestimmten Wert, der zwischen den Hoch- und Tiefwerten der Sicherung liegt, in dem anderen Zweig platziert ist.

6. Schaltung nach Anspruch 5, **dadurch gekennzeichnet, dass** der Bistable Latch in jedem der Zweige einen P-Kanal-Transister in Serie mit einem N-Kanal-Transistor umfasst, wobei die Gates der Transistoren (P1, N1) des ersten Zweiges mit dem Verbindungsknoten (B) der Transistoren des zweiten Zweiges verbunden sind, und die Gates der Transistoren (P2, N2) des zweiten Zweiges mit dem Verbindungsknoten (A) der Transistoren des ersten Zweiges verbunden sind

7. Schaltung nach Anspruch 5 oder 6, **dadurch gekennzeichnet, dass** sie Mittel (P3, N3) aufweist zum Reprogrammieren des Bistable Latchs.
